# EUROPEAN PATENT APPLICATION

(11) **EP 4 545 993 A1**
(43) Date of publication of application: **30.04.2025**
(21) Application number: 23827333.8
(22) Date of filing: 03.04.2023
(51) Int. Cl.: G01R 31/389, G01R 31/396, G01R 31/367, G01R 31/371, G01R 31/36, G01R 31/3842

(54) **IMPEDANCE MEASUREMENT SYSTEM AND OPERATION METHOD THEREOF**

(30) Priority: 24.06.2022 KR 20220077857
(71) Applicant: LG Energy Solution, Ltd., Seoul 07335 (KR)
(72) Inventor: CHOI, Yean Sik, Daejeon 34122 (KR)
(74) Representative: Goddar, Heinz J.
(86) International application number: PCT/KR2023/004476
(87) International publication number: WO 2023/249213

(57) **Abstract**

A battery pack includes at least one battery cell, a verification circuit connected to the at least one battery cell and including a load, and a controller configured to control the verification circuit to output information about an impedance of the load in response to a first command and control the verification circuit to output information about an impedance of the at least one battery cell in response to a second command.

## Description

### [TECHNICAL FIELD]

### CROSS-REFERENCE TO RELATED APPLICATION

This application claims priority to and the benefit of Korean Patent Application No. 10-2022-0077857 filed in the Korean Intellectual Property Office on June 24, 2022, the entire contents of which are incorporated herein by reference.

### TECHNICAL FIELD

Embodiments disclosed herein relate to an impedance measurement system and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To analyze a state of a battery and detect operating characteristics of the battery over time, electrochemical impedance spectroscopy may be used. The electrochemical impedance spectroscopy may quickly and accurately detect impedance which is a factor hindering electricity transmission when a chemical reaction occurs at an electrode included in the battery.

The state of the battery may be quickly evaluated by detecting the impedance, and it is possible to inspect battery quality, predict the remaining life, and optimize a charging method corresponding to the state of the battery, based on the evaluation.

### [DISCLOSURE]

### [TECHNICAL PROBLEM]

Embodiments disclosed herein aim to provide a measurement system capable of effectively measuring an impedance of a battery cell, and an operating method thereof.

Embodiments disclosed herein also aim to provide a battery pack including a verification circuit for verifying reliability of an impedance measurement system, and an operating method thereof.

Technical problems of the embodiments disclosed herein are not limited to the above-described technical problems, and other unmentioned technical problems would be clearly understood by one of ordinary skill in the art from the following description.

### [TECHNICAL SOLUTION]

A battery pack according to an embodiment of the present invention includes at least one battery cell, a verification circuit connected to the at least one battery cell and including a load, and a controller configured to control the verification circuit to output information about an impedance of the load in response to a first command and control the verification circuit to output information about an impedance of the at least one battery cell in response to a second command.

According to an embodiment, the verification circuit may include a first switch and a second switch, and the controller may be further configured to control the second switch to be opened when the first switch is short-circuited, and control the first switch to be opened when the second switch is short-circuited.

According to an embodiment, the first switch may be connected to the load, and the second switch may be connected between the first switch and the battery cell.

According to an embodiment, the controller may be further configured to control the first switch to be short-circuited in response to the first command and control the second switch to be short-circuited in response to the second command.

According to another embodiment of the present invention, an impedance measurement system includes a battery pack including at least one battery cell and a load and configured to output information about an impedance of the at least one battery cell or information about an impedance of the load and a measurement module configured to transmit different commands to the battery pack to output information from the battery pack.

According to an embodiment, the different commands may include a first command and a second command, and the measurement module may be further configured to transmit the first command or the second command to the battery pack.

According to an embodiment, the battery pack may be further configured to output the information about the impedance of the load in response to the first command and output the information about the impedance of the at least one battery cell in response to the second command.

According to an embodiment, the measurement module may be further configured to compare the information about the impedance of the load with a preset value to verify reliability of the measurement system.

According to an embodiment, the different commands may include a second command, and the measurement module may be further configured to transmit the second command to the battery pack when reliability of the measurement system is verified.

According to an embodiment, the measurement module may be further configured to measure an impedance of the load based on the information about the impedance of the load and determine whether the measured impedance of the load and the preset value fall within a preset range to verify reliability of the measurement system.

According to an embodiment, the measurement module may be further configured to measure the impedance of the at least one battery cell based on the information about the impedance of the at least one battery cell.

According to an embodiment, the measurement module may include an electrochemical impedance spectroscopic apparatus.

An operating method of an impedance measurement system according to another embodiment of the present invention includes transmitting, by a measurement module, a first command to a battery pack, controlling, by a controller, a first switch included in a verification circuit, to be short-circuited in response to the first command, outputting, by the battery pack, information about an impedance of a load included in the verification circuit, comparing, by the measurement module, the information about the impedance of the load with a preset value to verify reliability of the measurement system, transmitting, by the measurement module, a second command to the battery pack according to a result of reliability verification, controlling, by the controller, a second switch included in the verification circuit, to be short-circuited in response to the second command, outputting, by the battery pack, information about an impedance of at least one battery cell, and measuring, by the measurement module, the impedance of the at least one battery cell based on the information about the impedance of the at least one battery cell.

According to an embodiment, the controller may be further configured to control the second switch to be opened when the first switch is short-circuited, and control the first switch to be opened when the second switch is short-circuited.

According to an embodiment, the verifying of the reliability of the measurement system may include measuring, by the measurement module, the impedance of the load based on the information about the impedance of the load and determining, by the measurement module, whether the measured impedance of the load and the preset value fall within a preset range.

According to an embodiment, the operating method may further include notifying a user of occurrence of a problem in reliability of the measurement system when the measured impedance of the load and the preset value do not fall within the preset range.

### [ADVANTAGEOUS EFFECTS]

An impedance measurement system and an operating method thereof according to an embodiment disclosed herein may verify reliability of the measurement system.

A battery pack according to an embodiment disclosed herein may include a verification circuit and verify the reliability of the measurement system through the verification circuit.

The impedance measurement system and the operating method thereof according to an embodiment disclosed herein may diagnose a state of a battery cell.

Moreover, various effects recognized directly or indirectly from the disclosure may be provided.

### [Description of Drawings]

FIG. 1 is a block diagram of an impedance measurement system according to an embodiment disclosed herein.
FIG. 2 shows in detail a battery pack according to an embodiment disclosed herein.
FIG. 3 is a flowchart illustrating an operating method of an impedance measurement system according to an embodiment disclosed herein.
FIG. 4 is a flowchart illustrating an operating method of an impedance measurement system according to another embodiment disclosed herein.
FIG. 5 is a block diagram of a hardware configuration of a computing system for performing an operating method of an impedance measurement system, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

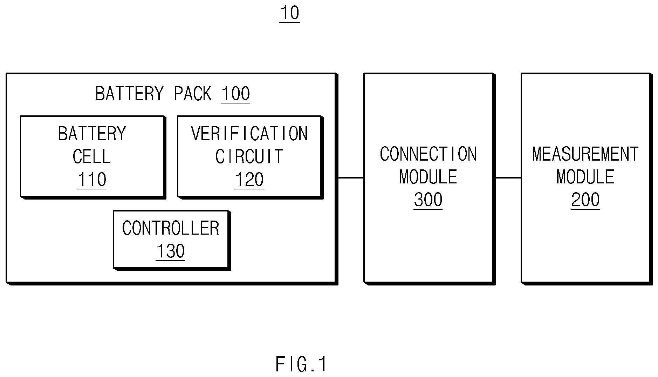

FIG. 1 is a block diagram of an impedance measurement system according to an embodiment disclosed herein.

Referring to FIG. 1, an impedance measurement system 10 according to an embodiment disclosed herein may include a battery pack 100, a measurement module 200, and a connection module 300.

The battery pack 100 may include at least one battery cell 110, a verification circuit 120, and a controller 130.

The verification circuit 120 may be connected to the battery cell 110 and include a plurality of switches and loads.

The controller 130 may control the verification circuit 120 such that the battery pack 100 may output information about an impedance of the battery cell 110 or information about an impedance of a load.

The measurement module 200 may transmit a command to the battery pack 100 and receive information about an impedance of a load included in the verification circuit 120 or information about an impedance of the battery cell 110 from the battery pack 100 in response to the command.

The measurement module 200 may measure the impedance based on the information about the impedance and compare the measured impedance with a preset value to verify reliability of the impedance measurement system 10.

The measurement module 200 may include, for example, an electrochemical impedance spectroscopic apparatus. The electrochemical impedance spectroscopic apparatus may measure an alternating current impedance spectrum of the battery cell 110 by using a non-destructive testing method. According to an embodiment, by comparing the measured alternating current impedance spectrum with an equivalent circuit model of the battery cell 110, deterioration and performance of the battery cell 110 may be estimated.

The electrochemical impedance spectroscopic apparatus may measure an alternating current impedance spectrum based on a change in amplitude and phase of a current signal detected from the battery cell 110 with respect to a change in frequency of alternating current (AC) power applied to the battery cell 110.

The measurement module 200 may be connected to the battery cell 110 that is subject to impedance measurement, through the connection module 300. The connection module 300 may include a plurality of lines (e.g., a wire harness or cable, etc.) and/or connection units (e.g., a terminal, a connector, etc.).

When the line and/or connection unit is aged or noise is generated in the measurement module 200, an error may occur in the information about the impedance of the battery cell 110 that is a measurement target.

When the error occurs in the information about the impedance of the battery cell 110, an error may occur in the alternating current impedance spectrum and an accurate state of the battery cell 110 may be difficult to diagnose. In addition, the reliability of the impedance measurement system 10 may not be secured.

When the impedance measurement system 10 or the battery pack 200 according to an embodiment of the present invention is used, an error occurring in the line and/or connection unit or an error occurring in the measurement module 200 may be checked before measurement of the impedance of the battery cell 110 to secure reliability of the impedance measurement system 10.

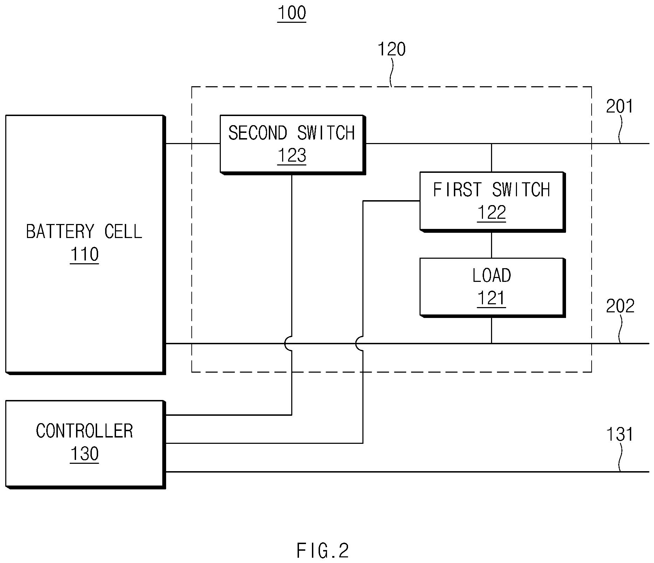

FIG. 2 shows in detail a battery pack according to an embodiment disclosed herein.

A connection state among the battery cell 110, the verification circuit 120, and the controller 130 is shown in detail in FIG. 2.

The battery pack 100 may be connected to a connection module (300 of FIG. 1) through a plurality of terminals, and the connection module 300 may be connected to an external device (e.g., the measurement module 200) through terminals different from the plurality of terminals. The battery pack 100 may receive a command signal, power, etc., from the external device and transmit information about an impedance, etc., to the external device, through the connection module 300.

The battery pack 100 may include the at least one battery cell 110 which may be charged or discharged by external power.

The battery cell 110 may be connected to the verification circuit 120. The battery cell 110 may be connected to the connection module 300 through a first wire 201 and a second wire 202, and the connection module 300 connected to the first wire 201 and the second wire 202 may be connected to a measurement module (200 of FIG. 1). According to an embodiment, the first wire 201 may be at a positive (+) terminal side and the second wire 202 may be a negative (-) terminal side.

The measurement module 200 may apply alternating current power to the battery pack 100.

More specifically, the alternating current power applied to the measurement module 200 may be applied to the battery pack 100 through the first wire 201 and the second wire 202 via the connection module 300.

The verification circuit 120 may include a load 121, a first switch 122, and a second switch 123.

The load 121 and the first switch 122 may be connected between the first wire 201 and the second wire 202, and the second switch 123 may be connected between the first switch 122 and the battery cell 110.

According to an embodiment, the load 121 may have a resistive element having a preset impedance value.

The first switch 122 and the second switch 123 are elements for controlling current flow of the battery pack 100, and at least one relay, a magnetic contactor, etc., may be used as an example. The relay and the contactor may be performed by the controller 130.

The controller 130 may monitor a voltage, a current, a temperature, etc., of the battery cell 110. According to an embodiment, the controller 130 may include a battery management system (e.g., an RBMS) that performs a control operation to prevent overcharge, over-discharge, etc., when the battery cell 110 is charged.

The controller 130 may control switches included in the battery pack 100 based on a monitored parameter and control current flow of the battery cell 110.

According to an embodiment, the controller 130 may output control signals for a plurality of switches included in the battery pack 100 based on a parameter and output the control signals for the plurality of switches based on a command received from outside.

The controller 130 may include a plurality of sensors for monitoring a state of the battery cell 110. The controller 130 may be an interface that receives various parameter measurement values for a battery. The controller 130 may include a plurality of terminals, a circuit that processes input values in connection with these terminals, etc.

The controller 130 according to an embodiment of the present invention may be implemented with a processor (e.g., an MCU, an ECU), and may be connected to external devices of the battery pack 100 through the plurality of terminals.

For example, the measurement module 200 may control the controller 130 through a command line 131.

More specifically, a command applied by the measurement module 200 may be transmitted to the controller 130 through a command line 131 via the connection module 300.

The command applied by the measurement module 200 may include a first command and/or a second command.

The controller 130 may control the verification circuit 120 in response to the received first command or second command. Upon receiving the first command, the controller 130 may control the first switch 122 to be short-circuited (an ON state) and the second switch 123 to be opened (an OFF state). Upon receiving the second command, the controller 130 may control the second switch 123 to be short-circuited (the ON state) and the first switch 122 to be opened (the OFF state).

Once the first switch 122 is short-circuited and the second switch 123 is opened, power may not be applied to the battery cell 110. That is, when the measurement module 200 transmits the first command to the controller 130, current corresponding to power applied by the measurement module 200 to the battery pack 100 may be output to the measurement module 200 through the load 121. In this case, the information about the impedance of the load 121 may be output from the battery pack 100.

Once the second switch 123 is short-circuited and the first switch 122 is opened, power may be applied to the battery cell 110. That is, when the measurement module 200 transmits the second command to the controller 130, current corresponding to power applied by the measurement module 200 to the battery pack may be output to the measurement module 200 through the battery cell 110. In this case, the information about the impedance of the battery cell 110 may be output from the battery pack 100.

According to an embodiment, the controller 130 may transmit signals for adjusting the first switch 122 and the second switch 123 in response to the first command and the second command. The controller 13 may perform exclusive adjustment to short-circuit any one of the first switch 122 and the second switch 123.

The measurement module 200 may measure the impedance of the load 121 based on information about the impedance of the load 121. The measurement module may compare the measured impedance of the load 121 with a preset value to verify the reliability of the measurement system 10. The preset value may be an actual impedance of the load 121.

More specifically, when the measured impedance of the load 121 falls within a preset range from the actual impedance of the load 121, the measurement module 200 may determine that the reliability of the measurement system 10 is secured. When the measured impedance of the load 121 does not fall within the preset range from the actual impedance of the load 121, the measurement module 200 may determine that the reliability of the measurement system 10 is not secured. According to an embodiment, when the wire and/or connection unit included in the measurement system 10 is aged or noise is generated in the measurement module 200, the reliability of the measurement system 10 may not be secured.

When the reliability of the measurement system 10 is not secured, the measurement system 10 may notify a user that a problem occurs in the reliability of the measurement system 10. According to an embodiment, the measurement system 10 may include visual and an audible means capable of transmitting an alarm to a user. For example, the visual means may include a display, a lamp, etc., and the audible means may include a speaker, etc.

The measurement module 200 may sequentially transmit the first command and the second command to the battery pack 100. The measurement module 200 may transmit the first command, and when the reliability of the measurement system 10 is secured, the measurement module 200 may transmit the second command to the battery pack 100 based on the received information about the impedance of the load 121. The measurement module 200 may measure the impedance of the battery cell 110 based on the received information about the impedance of the battery cell 110.

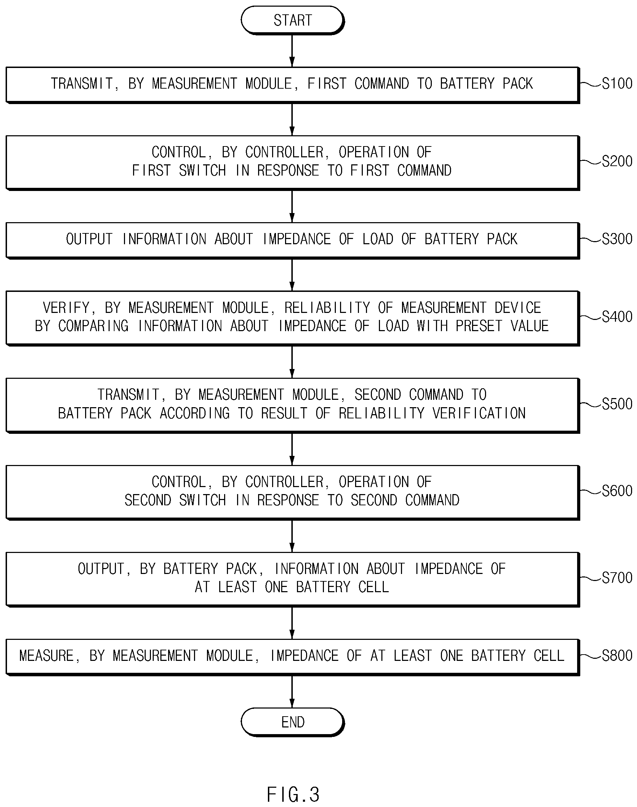

FIG. 3 is a flowchart illustrating an operating method of an impedance measurement system according to an embodiment disclosed herein.

To secure the reliability of the measurement system 10 and measure the impedance of the battery cell 11, the measurement module 200 may transmit the first command to the battery pack 100, in operation S100.

The measurement module 200 may be connected to the connection module 300 and transmit a command to the battery pack 300 through the connection module 300.

More specifically, the command applied by the measurement module 200 may be transmitted to the controller 130 included in the battery pack 100 through a command line 131 via the connection module 300, and the measurement module 200 may control the controller 130 based on the command.

The controller 130 may control the first switch 122 included in the verification circuit 120 to be short-circuited in response to the received first command, in operation S200. In response to the first command, the controller 130 may control the first switch 122 to be turned ON and the second switch 123 to be turned OFF.

As the first switch 122 is turned ON and the second switch 123 is turned OFF, a load positioned between the first wire 201 and the second wire 202 may be electrically connected to the first wire 201 and the second wire 202, and the battery cell 110 may be electrically separated from the first wire 201 and the second wire 202.

As the load 121 is electrically connected to the first wire 201 and the second wire 202, the battery pack 100 may output the information about the impedance of the load 121 included in the verification circuit 120, in operation S300.

The load 121 may be a resistive element and have a preset impedance.

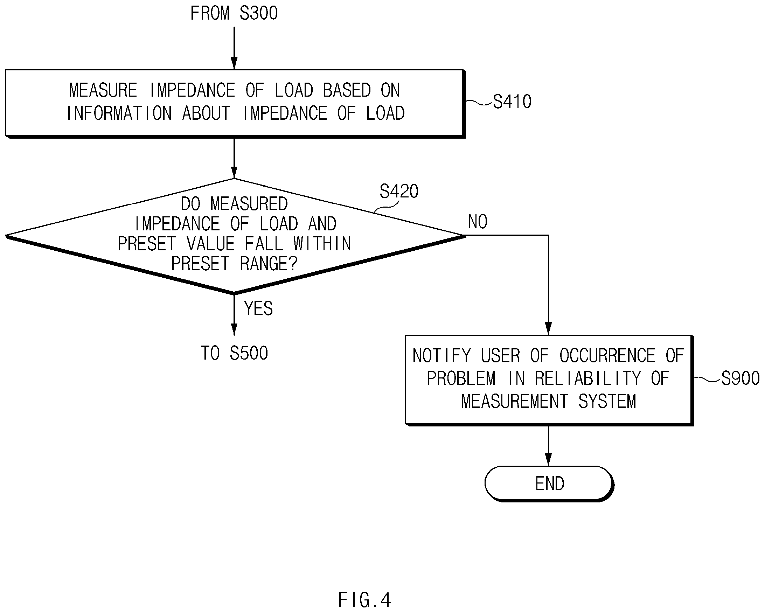

The measurement module 200 may compare the information about the impedance of the load 121 with a preset value to verify the reliability of the measurement system 10, in operation S400. A method for the measurement module 200 to verify the reliability of the measurement system 10 will be described in detail with reference to FIG. 4.

According to a result of reliability verification, the measurement module 200 may transmit a second command to the battery pack 100, in operation S500.

The measurement module 200 may transmit the second command to the controller 130 through the command line 131. The controller 130 may control the second switch 123 included in the verification circuit 120 to be short-circuited based on the received second command, in operation S600. Based on the second command, the controller 130 may control the second switch 123 to be turned ON and the first switch 122 to be turned OFF.

As the second switch 123 is turned ON and the first switch 122 is turned OFF, a load positioned between the first wire 201 and the second wire 202 may be electrically separated from the first wire 201 and the second wire 202, and the battery cell 110 may be electrically connected to the first wire 201 and the second wire 202.

As the battery cell 110 is electrically connected to the first wire 201 and the second wire 202, the battery pack 100 may output the information about the impedance of the battery cell 110, in operation S700.

The measurement module 200 may measure the impedance of the battery cell based on the information about the impedance of the battery cell 110. The measurement module 200 may calculate an impedance spectrum of the battery cell based on the information about the impedance of the battery cell 110 and compare the calculated impedance spectrum of the battery cell with an equivalent circuit module of the battery cell 110 to estimate deterioration and performance of the battery cell 110.

FIG. 4 is a flowchart illustrating an operating method of an impedance measurement system according to another embodiment disclosed herein.

In FIG. 4 are shown a method of measuring, by the measurement module 200 included in the impedance measurement system 10, the impedance of the load 121 and an operation of notifying the user of a result of reliability verification of the measurement system 10.

When the measurement module 200 receives information about the impedance of the load 121 from the battery pack 100 as indicated by FROM S300, the measurement module 200 may measure the impedance of the load 121 based on the information about the impedance of the load 121 in operation S410.

The measurement module 200 may measure the impedance of the load 121 based on power applied to the battery pack 100 and the information about the impedance of the load 121.

The measurement module 200 may determine whether the measured impedance of the load 121 and a preset value fall within a preset range, in operation S420.

The measurement module 200 may store an actual impedance of the load 121, and the actual impedance may be the preset value.

When the preset value and the measured impedance of the load 121 fall within the preset range as indicated by YES in operation S420, the measurement module 200 may transmit the second command to the battery pack 100 in operation S500 and receive the information about the impedance of the battery cell 110 from the battery pack 100.

When the preset value and the measured impedance of the load 121 do not fall within the preset range as indicated by NO in operation S420, the measurement module 200 may determine that a problem occurs in the reliability of the measurement system 10.

The measurement module 200 may notify the user of the occurrence of the problem in the reliability of the measurement system 10, in operation S900. The measurement module 200 may notify the user of the occurrence of the problem by using a visual notification device, an audible notification device, etc., and terminate measurement of the impedance of the battery cell 110 when the problem occurs in the reliability of the measurement system 10.

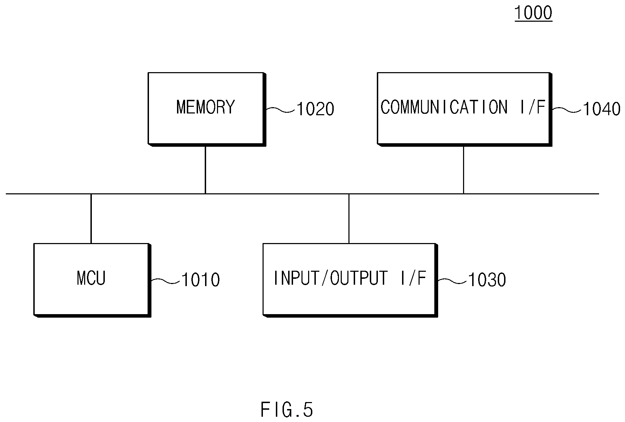

FIG. 5 is a block diagram of a hardware configuration of a computing system for performing an operating method of an impedance measurement system, according to an embodiment disclosed herein.

Referring to FIG. 5, a computing system 1000 according to an embodiment disclosed herein may include an MCU 1010, a memory 1020, an input/output I/F 1030, and a communication I/F 1040.

According to an embodiment, the computing system 1000 may be a system for performing the above-described operation of the controller 130 or measurement module 200.

The MCU 1010 may be a processor that executes various programs stored in the memory 1020.

For example, the MCU 1010 may process voltage, current data, a command signal, a switch control signal, etc., of the battery cell 110 required for the controller 130 to manage and control the battery cell 110 and/or the battery pack 100. The MCU 1010 may be a processor for processing data and/or a signal.

In addition, the MCU 1010 may be a processor for adjusting current applied to the battery pack 100 in order for the measurement module 200 to measure the impedance of the battery cell 110 and/or the load 121 and executing impedance calculation based on information output from the battery pack 100. The MCU 1010 may be a processor for processing data and/or a signal.

The memory 1020 may store various programs required for managing and controlling the battery pack 100. The memory 1020 may also store various programs required for measuring an impedance.

For example, the memory 1020 may store various data such as voltage, current, feature data, etc., of each battery cell 110. Moreover, the memory 102 may store a program for calculating an impedance based on a voltage, a current, feature data, etc., of each battery cell 110. The memory 1020 may be provided in plural, depending on a need.

The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a program or various data, etc., for impedance detection of the battery cell 110 may be transmitted and received to and from a separately provided external server through the communication I/F 1040.

As such, a computer program according to an embodiment disclosed herein may be recorded in the memory 1020 and processed by the MCU 1010, thus being implemented as a module that performs functions shown in FIGS. 1 to 4.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery pack comprising:
at least one battery cell;
a verification circuit connected to the at least one battery cell and comprising a load; and
a controller configured to control the verification circuit to output information about an impedance of the load in response to a first command and control the verification circuit to output information about an impedance of the at least one battery cell in response to a second command.

2. The battery pack of claim 1, wherein the verification circuit comprises a first switch and a second switch, and
the controller is further configured to control the second switch to be opened when the first switch is short-circuited, and control the first switch to be opened when the second switch is short-circuited.

3. The battery pack of claim 2, wherein the first switch is connected to the load, and the second switch is connected between the first switch and the battery cell.

4. The battery pack of claim 2, wherein the controller is further configured to control the first switch to be short-circuited in response to the first command and control the second switch to be short-circuited in response to the second command.

5. An impedance measurement system comprising:
a battery pack comprising at least one battery cell and a load and configured to output information about an impedance of the at least one battery cell or information about an impedance of the load; and
a measurement module configured to transmit different commands to the battery pack to output information from the battery pack.

6. The impedance measurement system of claim 5, wherein the different commands comprise a first command and a second command, and
the measurement module is further configured to transmit the first command or the second command to the battery pack.

7. The impedance measurement system of claim 6, wherein the battery pack is further configured to output the information about the impedance of the load in response to the first command and output the information about the impedance of the at least one battery cell in response to the second command.

8. The impedance measurement system of claim 5, wherein the measurement module is further configured to compare the information about the impedance of the load with a preset value to verify reliability of the measurement system.

9. The impedance measurement system of claim 8, wherein the different commands comprise a second command, and
the measurement module is further configured to transmit the second command to the battery pack when reliability of the measurement system is verified.

10. The impedance measurement system of claim 8, wherein the measurement module is further configured to measure an impedance of the load based on the information about the impedance of the load and determine whether the measured impedance of the load and the preset value fall within a preset range to verify reliability of the measurement system.

11. The impedance measurement system of claim 5, wherein the measurement module is further configured to measure the impedance of the at least one battery cell based on the information about the impedance of the at least one battery cell.

12. The impedance measurement system of claim 5, wherein the measurement module comprises an electrochemical impedance spectroscopic apparatus.

13. An operating method of an impedance measurement system, the operating method comprising:
transmitting, by a measurement module, a first command to a battery pack;
controlling, by a controller, a first switch included in a verification circuit, to be short-circuited in response to the first command;
outputting, by the battery pack, information about an impedance of a load included in the verification circuit;
comparing, by the measurement module, the information about the impedance of the load with a preset value to verify reliability of the measurement system;
transmitting, by the measurement module, a second command to the battery pack according to a result of reliability verification;
controlling, by the controller, a second switch included in the verification circuit, to be short-circuited in response to the second command;
outputting, by the battery pack, information about an impedance of at least one battery cell; and
measuring, by the measurement module, the impedance of the at least one battery cell based on the information about the impedance of the at least one battery cell.

14. The operating method of claim 13, wherein the controller is further configured to control the second switch to be opened when the first switch is short-circuited, and control the first switch to be opened when the second switch is short-circuited.

15. The operating method of claim 14, wherein the verifying of the reliability of the measurement system comprises:
measuring, by the measurement module, the impedance of the load based on the information about the impedance of the load; and
determining, by the measurement module, whether the measured impedance of the load and the preset value fall within a preset range.

16. The operating method of claim 15, further comprising notifying a user of occurrence of a problem in reliability of the measurement system when the measured impedance of the load and the preset value do not fall within the preset range.
